(19) **Europäisches Patentamt / European Patent Office / Office européen des brevets**

(11) **EP 3 966 490 B1**

(12) **EUROPEAN PATENT SPECIFICATION**

(45) Date of publication and mention
of the grant of the patent:
**13.03.2024 Bulletin 2024/11**

(21) Application number: **20727842.5**

(22) Date of filing: **30.04.2020**

(51) International Patent Classification (IPC):
***F17D 3/12*** *(2006.01)*

(52) Cooperative Patent Classification (CPC):
**F17D 3/12;** F17C 2265/027

(86) International application number:
**PCT/IB2020/054069**

(87) International publication number:
**WO 2020/225659 (12.11.2020 Gazette 2020/46)**

(54) **DEVICE FOR MEASURING AND CONTROLLING A GAS**

VORRICHTUNG ZUR MESSUNG UND REGELUNG EINES GASES

DISPOSITIF DE MESURE ET DE CONTRÔLE D'UN GAZ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.05.2019 IT 201900006607**

(43) Date of publication of application:
**16.03.2022 Bulletin 2022/11**

(73) Proprietor: **REGAS S.P.A.**
**20125 Milano (MI) (IT)**

(72) Inventor: **JAMOLETTI, Francesco**
**24053 Brignano Gera D'Adda**
**BG (IT)**

(74) Representative: **Ziliotto, Tiziano**
**Studio Ziliotto**
**Contrada Porta Santa Lucia, 48**
**36100 Vicenza (IT)**

(56) References cited:
**EP-A2- 1 030 098**    **US-A- 3 634 053**
**US-A- 3 686 930**    **US-A- 3 854 894**
**US-A1- 2014 149 054**

**Description**

TECHNICAL FIELD OF THE INVENTION

The present invention concerns a gas measuring and controlling device. More specifically, it concerns a device that makes it possible to measure a characteristic of a gas and to control physical characteristics of the gas based on the measured characteristic.

STATE OF THE ART

The natural gas distributed by national gas networks is an odourless gas and, in order to allow users to perceive any leaks, small quantities of odorant gas with a recognizable odour are added thereto. Odorant gas usually comprises tert-butyl mercaptan (TMB) and/or tetrahydrothiophene (THT).

The odorant gas, preferably in the liquid form, is introduced in the natural gas distribution network by means of injectors. In Italy, for example, a standard concentration of odorant gas is 10mg/Sm$^3$ for TBM, that is, approximately 2.5ppm, while it is 32mg/Sm$^3$ for THT, that is, approximately 8ppm. It is important to ensure that the concentration of odorant gas remains within a pre-established range of values, since an excessively small quantity could not be enough to be perceived by the users in case of leak. On the contrary, an excessively high concentration may give false positives, so that small gas leaks, allowed for by the system design, may be perceived as a problem by the user.

The need to maintain the concentration of odorant gas within a specific interval introduces a series of technical problems. More specifically, it requires that the odorant gas injectors constantly work without malfunctions, or that they be checked periodically, which causes operating costs to increase. Furthermore, another problem is the fading of the odorant gas in the pipelines. More specifically, sulphur compounds such as, for example, TBM and THT, may produce a decay effect if they remain in contact with the pipelines, possibly in the presence of iron oxide, for very long times, for example weeks. These operating conditions may occur, for example, if the gas demand is low, if the network pressures are set in a certain way and if the mesh network includes long routes to reach specific users or areas.

In order to guarantee that the concentration of odorant gas is correct, the composition of the gas inside the natural gas transport and distribution system is presently carried out through occasional sample analyses which are performed using portable equipment.

This solution, however, is not very effective, since a technician must go to the measurement site and carry the measuring equipment along. More specifically, technicians nowadays use portable gas chromatographs. This type of instrument requires high precision and at the same time is very delicate. It must be recharged every day and serviced approximately once a year. This makes this kind of instrument very expensive. Furthermore, the instruments available on the market are rather heavy to transport, in fact they weigh approximately 20 kg, and are not automated. Thus, the technician needs to connect the instrument to the measurement point, start the analysis and save the results. Once having obtained the results, he/she sends the relevant report to the person/body responsible for receiving it. Therefore, the application of the procedure in real time is not possible. Alternatively, instead of using portable equipment, it is possible to carry out the measurement by collecting a gas sample and physically bringing it to a lab. The gas is then analysed with very precise instruments and the results are communicated a few days later. This application cannot provide any results in real time, either.

Based on the results obtained in this way, it is then possible to adjust the injector, where necessary.

In similar applications, in which, however, the characteristics to be measured are not those of the odorant gas, the need for a measuring procedure in line with the distribution process has led to the widespread use of instruments based on less accurate physical principles such as, for example, electrochemical cells. These instruments are suitable for remote applications but in the case of odorant gas cannot guarantee sufficient precision for the type of measurement to be carried out, due to the low concentration of odorant gas. Another example of equipment typically suited to be installed in line for the purpose of measuring the compounds contained in a gas is the equipment based on optical techniques. However, this solution does not provide the precision which is necessary for measuring concentrations like those described above for odorant gas, either.

A type of sensor that makes it possible to measure gas concentrations with the required precision is a gas chromatography sensor.

To date, however, this sensor has not been used for the remote and in-line measurement of odorant gases. One of the reasons why this use has not been possible lies in that an expert technician must be present on site to read the measured value and adjust the injector. This need makes any real time measurement useless, as any reaction to the measurement requires the presence of a technician on site.

Nothing is known to have been done in the industrial field to feedback the measurement of a gas composition by adjusting pressures, flow rates, compound injection levels or other parameters. A difficulty in the implementation of an automatic management system for the injector based on the measurement is given by the need to develop a mathematical model capable of representing faithfully the physics of the problem, which is typically based on non-linear relationships between flow rate and pressures. In addition, it is also difficult to feedback actuators capable of regulating the controlled variables. To date, no application of this kind is known.

Thus, it is an object of the present invention to provide a device that makes it possible to control one or more injectors of gas, preferably odorant gas, based on a measurement of a physical characteristic of the gas, preferably carried out by means of a gas chromatography sensor.

Devices according to the state of the art are known, for instance, from US 3 634 053 A, US 3 854 894 A, US 3 686 930 A. EP 1 030 098 A2 and US 2014/149054 A1.

SUMMARY OF THE INVENTION

The invention concerns a device for measuring and controlling a gas according to the independent claim. Advantageous embodiments of the invention are also defined in the dependent claims.

More specifically, the invention may concern a calculation method for positioning sensors designed to measure an odorant gas in a natural gas network, comprising the following steps: acquisition of data representing the physical state of the natural gas network,

> simulation of the natural gas network,
> calculation for the positioning of odorant gas sensors.

In some embodiments, the data acquisition step (1010) may comprise the acquisition of one or more among:

- topographic data of network nodes,
- geometric data of pipelines,
- load conditions,
- coverage factor of the measuring sensors with respect to the critical areas defined based on the natural gas residence time inside the pipelines.

In some embodiments, the load conditions may comprise one or more among natural gas inlet points, natural gas outlet points, maximum outlet values, and the input of the pressure levels at the control stations.

In some embodiments, the simulation step may comprise a Monte Carlo simulation of the structure of the natural gas network.

In some embodiments, the natural gas network may comprise a plurality of network nodes and a plurality of pipelines and the simulation step may comprise the calculation of the average travel time for each pair of nodes.

In some embodiments, the calculation of the average travel time may comprise the calculation of the pressure drop in a i-th pipeline according to the equation

$$\text{Eq. 1)} \quad \frac{\partial \Delta P_i}{\partial m_i} = \frac{f_i \, |m_i| \, L_i}{D_i \frac{PM}{RT} A_i^2 P_{i,out}}$$

where

> $\Delta P$ = pressure drop
> $P$ = pressure
> $m$ = mass flow rate
> $f$ = friction factor
> $L$ = pipeline length
> $D$ = pipeline diameter
> $P$ = reference pressure for the pipeline
> $M$ = molar mass of the gas in transit
> $R$ = universal gas constant
> $T$ = reference temperature for the pipeline under assumption of isothermality
> $A$ = pipeline cross section
> $P_{out}$ = pressure at pipeline outlet
> and where the "i" subscript indicates the i-th pipeline.

BRIEF LIST OF THE DRAWINGS

Further characteristics and advantages of the invention are highlighted more clearly in the following detailed description of preferred but not exclusive embodiments, illustrated by way of non-limiting example making reference to the attached drawings.
In the drawings, the same reference numbers identify the same components.
In particular:

- Figure 1 shows a schematic view of a flow chart illustrating a first embodiment of the invention;
- Figure 2 shows a schematic view of a natural gas network 2000;
- Figure 3 shows a schematic view of a part of the natural gas network 2000.

DESCRIPTION OF PREFERRED EMBODIMENTS

The following detailed description illustrates several embodiments, making reference to the figures. It is clear, however, that the present invention is not limited to the embodiments described and/or illustrated herein. More specifically, it is clear that different characteristics belonging to different embodiments may be combined with one another to obtain different embodiments. It is also clear that not all the characteristics of an individual embodiment are to be considered necessary for obtaining said embodiment. More specifically, in some cases certain characteristics may be described only for the purpose of clarifying the specific operation of the embodiment being described, even though they are not strictly necessary for the implementation of the invention. Furthermore, individual characteristics of a first and of a second embodiment may be combined with one another in such a way as to create a third embodiment of the invention without requiring the presence of all the other characteristics of the first and of the second embodiment.
Generally speaking, the invention concerns a control procedure that makes it possible to control the injector based on measurement data provided by a gas chromatography sensor. Such control poses inherent difficulties due to the correlation between the input data, meaning the sensor's output, and the output data, meaning the injector's input. In other words, it is difficult to optimize the introduction of the odorant based on a physical-analytical model capable of correctly describing the physics of the problem and thus of predicting/optimizing operation. There is also another difficulty related to the need to measure the odorant compound continuously with sufficient precision.
Again, generally speaking, the invention makes it possible to calculate the ideal position of the sensors for different types of natural gas network.
Generally speaking, the invention resolves these problems by measuring a plurality of inputs which, for example, may comprise:

- gas pressure at various points of the network
- volumetric gas flow rate at various points of the network
- concentration of compounds at various points of the network

and inputting these values in a physical-mathematical model, in such a way as to optimize a certain target function, for example the quantity of odorant to be introduced in the network and/or the specific injection points. This physical-mathematical model thus makes it possible to define the points where the sensors must be positioned. Once the sensors have been positioned, the invention provides for a control strategy based on a simplified dynamic model representing the network, an example of which can be a PID, Proportional-Integral-Derivative, feedback control, that is, a negative feedback system.

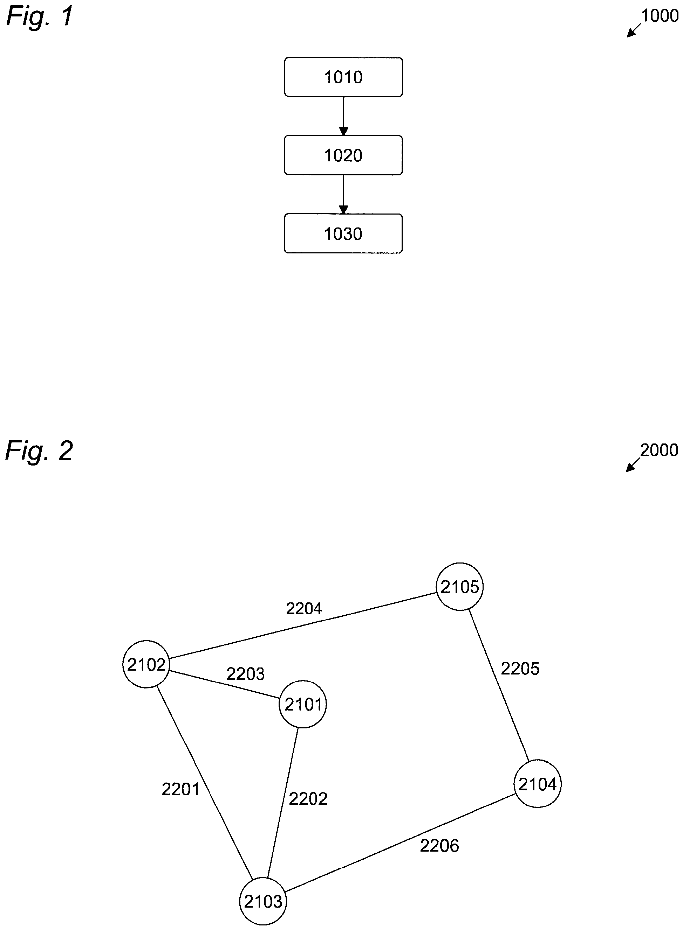

Figure 1 shows a schematic view of a flow chart illustrating a first embodiment of the invention. Generally speaking, this first embodiment makes it possible to calculate, based on the physical structure of the natural gas network 2000, the ideal position of the sensors for measuring an odorant gas. Figure 2 shows a schematic view of a natural gas network 2000. The natural gas network 2000 comprises a plurality of nodes 2101-2105 and of pipelines 2201-2206.
As can be seen in Figure 1, the method 1000 comprises a first step 1010 of acquisition of data representing the physical state of the natural gas network 2000.
The acquired data may comprise, specifically, one or more among:

- topographic data of the network nodes 2101-2105, for example their position in space,
- geometric data of the pipelines 2201-2206, for example diameter, length and roughness,
- load conditions such as, for example, one or more among natural gas inlet points, natural gas outlet points, maximum outlet values, and the input of the pressure levels at the control stations, meaning that the outlet pressure at the stations is assigned as boundary condition of the model,
- coverage factor of the measuring sensors with respect to the critical areas defined on the basis of the residence time of the natural gas inside the pipelines 2201-2206.

More specifically, the concentration of one or more odorant gases can be measured by means of a gas chromatography sensor.

Some of the data, in particular those related to pressure, flow rate and concentration, can be measured at one or more points of the natural gas network 2000. It will thus be possible to combine different values measured at different points in relation to the same type of data.

Step 1020 consists in the simulation of the natural gas network 2000.

In general terms, in some embodiments the network 2000 can be simulated through a simplified fluid dynamic model, whose boundary conditions represent different load conditions, for example:

- the night and day conditions in summer,
- the night and day conditions in winter,
- intermediate conditions.

The simulation model is generally based on the conservation of the mass applied to nodes 2101-2105 of the network 2000 and the momentum balance applied to pipelines 2201-2206. Furthermore, it is also possible to apply some hypotheses related to the conditions being examined, for example the assumption of isothermality of the gas in the network and the assumption of ideality of the gas for the simulated mixture.

In some embodiments, the simulation step 1020 may comprise a Monte Carlo simulation of the structure of the network 2000.

Furthermore, in some embodiments, the simulation step 1020 may comprise the calculation of the average travel time for each pair of network nodes 2201-2206. Based on this data, it is possible to define critical areas, such as those areas where the average travel time of the natural gas exceeds a predefined value, for example is more than 8 hours, more preferably more than 24 hours.

In particular, for a given pair of nodes, for example 2102 and 2103, there can be several routes, in turn made up of several pipelines, in this example the route through pipeline 2201, the route through pipelines 2203 and 2202, and the route through pipelines 2204, 2205 and 2206. The calculation of the average travel time for the pair of nodes 2102 and 2103 is thus made considering all the possible routes, using the individual flow rates of each route as weight. In some embodiments, this analysis can be made for all load conditions, with a Monte Carlo simulation, in such a way as to obtain a distribution of average travel times between the two nodes. From this distribution it is possible to establish the characteristic average time between the pair of nodes.

The calculation of the average travel time is preferably repeated for all the pairs of nodes of the network 2000, in such a way as to identify the critical nodes in terms of longer travel time.

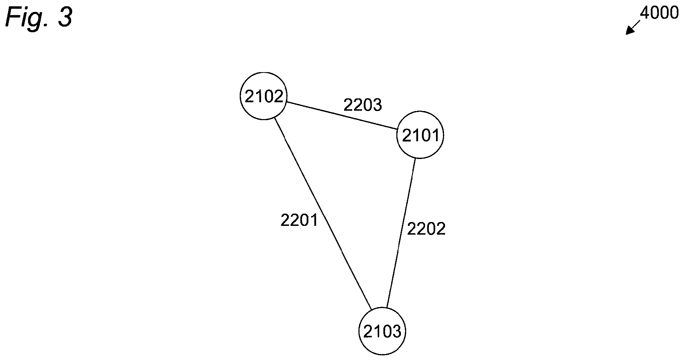

Figure 3 shows a schematic view of a part of the natural gas network 2000 that will be used for an example of a method of calculation of the average travel time. In a first step the first trial values are selected for the flow rates of each pipeline 2201-2203 and for the pressure at nodes 2101-2103. On the first iteration the pressures at nodes 2101-2103 are assumed to be the same as the pressure at node 2101, while the flow rates are such as to guarantee mass conservation in the network, the loads being known.

In a second step the pressure drops are linearized. As can be seen in the following equation 1

$$\text{Eq. 1)} \qquad \frac{\partial \Delta P_i}{\partial m_i} = \frac{f_i \left| m_i \right| L_i}{D_i \frac{PM}{RT} A_i^2 P_{i,out}}$$

the pressure drops in the pipeline are non-linearly dependent on the flow rate. In equation 1), the symbols are defined as follows:

- $\Delta P$ = pressure drop
- $P$ = pressure
- $m$ = mass flow rate
- $f$ = friction factor
- $L$ = pipeline length
- $D$ = pipeline diameter
- $P$ = reference pressure for the pipeline
- $M$ = molar mass of the gas in transit

- R = universal gas constant
- T = reference temperature for the pipeline under assumption of isothermality
- A = pipeline cross section
- Pout = pressure at pipeline outlet

and where the "i" subscript indicates the i-th pipeline.

In order to solve the system made up by the mass balances at nodes 2101-2103, defined by equation 2

$$\text{Eq. 2)} \quad \sum_{n=1}^{N_{p,n}} m_{i,n} = L_n$$

where Ln is the load at node n, and the momentum balances at pipelines 2201-2203, defined by equation 3

$$\text{Eq. 3)} \quad P_{i,out} = \sqrt{P_{i,in}^2 - \frac{f_i m_i |m_i| L_i}{D_i \frac{PM}{RT} A_i^2}}$$

equation 4) defining the pressure drops

$$\text{Eq. 4)} \quad \Delta P_i = P_{i,in} - P_{i,out}$$

is linearized and the system is solved with an iterative method, in equation 5) index k indicates the iteration:

$$\text{Eq. 5)} \quad \Delta P_i^{k+1} = \Delta P_i^k + \left.\frac{\partial \Delta P_i}{\partial m_i}\right|_k \left(m_i^{k+1} - m_i^k\right)$$

As shown in the equation above, the linearization is obtained by using a Taylor series expansion truncated at the first order. The derivative of the pressure drops as a function of the flow rate can be calculated analytically using the equation above.

In a third step the linear system is solved. Once the momentum balances at pipelines 2201-2203 have been linearized, it is possible to solve the linear system by using LU decomposition.

In a fourth step the convergence of the solution is verified. The convergence of the solution can be verified by comparing the solution to the preceding iteration with the new solution. If the two solutions are similar, the system is convergent. If the two solutions are different, the iterative process is resumed starting from the second step.

An example of application of the steps described above for the calculation of the average travel time is provided below.

The following table specifies the pipeline geometrical data, for example for pipelines 2201-2203, as input in the data acquisition step 1010:

| | Diameter [mm] | Length [m] | Roughness [mm] |
|---|---|---|---|
| Pipeline 2201 | 100 | 300 | 0.3 |
| Pipeline 2202 | 125 | 400 | 0.3 |
| Pipeline 2203 | 75 | 500 | 0.3 |

The loads applied to nodes 2101-2103, for example, are specified in the following table:

|  | Load [Nm$^3$/h] |
| --- | --- |
| Node 2101 | 0 |
| Node 2102 | 2124 |
| Node 2103 | 3158 |

The pressure at node 2101 is assumed to be equal to 4 bars and the gas properties are the average properties of the natural gas present in Italy.

Iteration 0: the following flow rates and pressures are assumed for the first iteration:

|  | Flow rate [Nm$^3$/h] | Node | Pressure [bar] |
| --- | --- | --- | --- |
| Pipeline 2201 | 1760.67 | 2101 | 4 |
| Pipeline 2202 | 1760.67 | 2102 | 4 |
| Pipeline 2203 | 1760.67 | 2103 | 4 |

In some embodiments, the initial values are selected by distributing the load set as boundary condition on the pipelines. This gives an initial estimation, which obviously does not take in consideration the pressure drops but makes it possible to satisfy the mass balance and accelerates the convergence of the iterative solver.

With these initial conditions, the following values are obtained for the derivative and the pressure drops:

|  | Derivative [barh/Nm$^3$] | Pressure drops [bar] |
| --- | --- | --- |
| Pipeline 2201 | 0.00027589 | 0.237 |
| Pipeline 2202 | 0.00011072 | 0.096 |
| Pipeline 2203 | 0.00369924 | 2.281 |

which lead to the following solution to the linear system:

|  | Flow rate [Nm$^3$/h] | Node | Pressure [bar] |
| --- | --- | --- | --- |
| Pipeline 2201 | -764.84 | 2101 | 4 |
| Pipeline 2202 | 3922.84 | 2102 | 3.152 |
| Pipeline 2203 | 1359.16 | 2103 | 3.612 |

By comparing the table above with the one assumed in iteration 0, it is possible to conclude that the two solutions are different and therefore it is necessary to proceed with a new iteration.

Iteration 1: the initial values of this iteration are the results given in the last table of iteration 0, which generate the following values for derivative and pressure drops:

|  | Derivative [barh/Nm$^3$] | Pressure drops [bar] |
| --- | --- | --- |
| Pipeline 2201 | 0 | -0.052 |
| Pipeline 2202 | 0 | 0.495 |
| Pipeline 2203 | 0.002 | 1.191 |

Using these values to solve the linear system, the following is obtained:

|  | Flow rate [Nm$^3$/h] | Node | Pressure [bar] |
|---|---|---|---|
| Pipeline 2201 | -1029.59 | 2101 | 4 |
| Pipeline 2202 | 4187.59 | 2102 | 3.294 |
| Pipeline 2203 | 1094.41 | 2103 | 3.383 |

Comparing the solution of the previous iteration with that of the current one, it is possible to observe a difference in the order of 300 Nm$^3$/h for the flow rates and of 0.3 bar for the pressures. These differences exceed a threshold level, therefore it is necessary to proceed with a further iteration.

In order to determine when the difference between the solutions of successive iterations can be considered acceptable, a realistic pattern of threshold values can be used. In some embodiments of the invention, the threshold values can be selected as:

-   threshold for the calculation of the ΔP value between two steps lower than 1%, more preferably lower than 0.5% and even more preferably lower than or equal to 0.1%
-   threshold for the flow rate, between two steps, preferably lower than 10-5, more preferably lower than 10-6
-   threshold for the total vector, between two steps, preferably lower than 10-6, more preferably lower than 10-7.

When all the convergence criteria are met, the cycle can be abandoned and the iterative system is considered solved.

Iteration 2: the new values for the derivatives and the pressure drops are the following:

|  | Derivative [barh/Nm$^3$] | Pressure drops [bar] |
|---|---|---|
| Pipeline 2201 | 0 | -0.091 |
| Pipeline 2202 | 0 | 0.568 |
| Pipeline 2203 | 0.001 | 0.735 |

Using these values to solve the linear system, the following is obtained:

|  | Flow rate [Nm$^3$/h] | Name | Pressure [bar] |
|---|---|---|---|
| Pipeline 2201 | -1069.43 | 2101 | 4 |
| Pipeline 2202 | 4227.43 | 2102 | 3.271 |
| Pipeline 2203 | 1054.56 | 2103 | 3.368 |

After this second iteration, the difference related to the flow rates has lowered to approximately 40 Nm3/h, while the difference related to the pressures to 0.03 bar. This value still exceeds the predetermined threshold value for this exemplification case and thus it is necessary to proceed with a new iteration.

Iteration 3: the results of the previous iteration give the following flow rate and pressure drop values:

| Name | Derivative [barh/Nm$^3$] | Pressure drop [bar] |
|---|---|---|
| Pipeline 2201 | 0 | -0.098 |
| Pipeline 2202 | 0 | 0.579 |
| Pipeline 2203 | 0.001 | 0.679 |

Using these values to solve the linear system, the following is obtained:

|  | Flow rate [Nm$^3$/h] | Node | Pressure [bar] |
|---|---|---|---|
| Pipeline 2201 | -1070.03 | 2101 | 4 |

(continued)

|  | Flow rate [Nm³/h] | Node | Pressure [bar] |
|---|---|---|---|
| Pipeline 2202 | 4228.03 | 2102 | 3.271 |
| Pipeline 2203 | 1053.97 | 2103 | 3.368 |

After the third iteration, the difference related to the flow rates has lowered to approximately 1 Nm³/h , while the difference related to the pressures is zero. It can thus be concluded that the solution is convergent, since both the differences are below their respective threshold values.

The solution obtained and the decay kinetics specified in the following equation:

$$\text{Eq. 6} \quad x_{i,out} = x_{i,in} \left( 1 - K \frac{A_i L_i}{m_i} \frac{P_i PM}{RT} \right)$$

using a K value equal to 10 1/h make it possible to calculate the concentration of odorant at the nodes. In embodiments of the invention, the K value can be selected within the range between 10 and 1000000.

The result is given in the following table:

| Node | mg/Nm³ |
|---|---|
| 2101 | 10 |
| 2102 | 9.76 |
| 2103 | 9.89 |

From this analysis provided by way of example it can thus be concluded that the two nodes 2102 and 2103 have an odorant concentration different from 10 mg/Nm³, due to the different average travel times.

On the base of the transported concentration, it is thus possible to calculate the average time between all the pairs of nodes according to equation 7):

$$\text{Eq. 7) } x\_node_i = x\_inlet\_point * (1 - k * t^{\wedge}(-alpha))$$

where

- x_node$_i$ is the concentration in the transported quantity at the i-th node;
- x_inlet_point is the concentration in the introduced quantity at the inlet point, therefore known;
- k is a parameter that indicates the decay curve slope, a known parameter;
- t is the average travel time between the two nodes under examination, which is thus obtained from equation 7) by reversing it;
- alpha is a set decay parameter, in this case = 1.

In this way, it is thus possible to calculate the travel time between any pair of nodes. As explained above, by averaging the travel times based on the flow rates, it is possible to obtain the average travel time between two nodes 2101-2015.

In this way it is possible to define the most critical areas for positioning the sensors. Once the sensors have been positioned, it is possible to use the value measured by the sensors to adjust the quantity of odorant to be introduced according to the feedback, taking into account the dynamics of the system.

In several countries, the manager of the natural gas network 2000 has the obligation to maintain the concentration of odorant within a predetermined interval. In the case illustrated by way of example, the interval can have a minimum value of 10 mg/Nm³. It is thus necessary to select the position of the odorant gas sensors in such a way as to ensure that the odorant gas is maintained within the predetermined interval.

Step 1030 consists in the calculation of the position of the odorant gas sensors inside the natural gas network 2000, based on the results obtained from step 1020.

In general, as described above, step 1020 provides an evaluation of the average travel time of natural gas between several pairs of nodes 2101-2105, in such a way as to identify the pipelines 2201-2206 where the average travel time of the gas exceeds a pre-established value.

More specifically, once the travel times have been calculated, as illustrated above, it is possible to position the gas chromatography sensors to cover the network according to a coverage factor provided as an input.

The procedure is thus the following:

- defining a coverage factor, for example equal to 90% and preferably exceeding 75%;
- calculating the critical areas according to a threshold transit time value, for example 8 hours. In some embodiments, this is possible thanks to the network topographic data received, complemented by the geolocalization of the nodes and the pipelines;
- once the critical geographic areas, defined as those areas with average travel time above the threshold value, have been identified, the number and position of the sensors are calculated based on the coverage radius of one sensor, which in the case of technology available on the market can be, for example, 0.5 km;
- in this way the number and position of the sensors designed to measure the odorant value with a predetermined frequency are obtained.

It is clear that, in order to define the configuration best suited to reduce transit times and therefore criticalities, the simulation can be made also with different conditions. In this way, the invention makes it possible to optimize the odorant level in the network through a design of the network and a feedback control.

The invention thus makes it possible to implement a control method for injectors designed to inject odorant gas in the natural gas network 2000. In particular, as described above, it is possible to calculate the position of the sensors for measuring an odorant gas by proceeding as described above. Once the ideal position of the sensors has been calculated, it is possible to position the sensors according to the results of the position calculation. Finally, it is possible to proceed to a feedback control of the odorant gas injectors, using the odorant gas values measured by said sensors as an input.

Thanks to this method, it is thus possible to guarantee that the quantity of odorant gas will be within the interval of pre-established values over the entire natural gas network 2000, independently of the configuration of the network.

Even though the invention has been described with reference to certain embodiments, each comprising one or more specific characteristics, it is clear that the invention should not be considered limited to said embodiments and that alternative embodiments can be obtained by combining one or more characteristics of the embodiments described and falling under the appended claims.

**Claims**

1. Calculation method (1000) for the positioning of sensors designed to measure an odorant gas in a natural gas network (2000), including the steps of:

   acquisition (1010) of data representing the physical state of the natural gas network (2000),
   simulation (1020) of the natural gas network (2000),
   calculation (1030) for the positioning of odorant gas sensors **characterised in that** the natural gas network (2000) comprises a plurality of network nodes (2101-2105) and a plurality of pipelines (2201-2206) and the simulation step (1020) includes the calculation of the average travel time for each pair of nodes (2201-2206).

2. Method according to claim 1, **wherein** the data acquisition step (1010) includes the acquisition of one or more among:

   - topographic data of network nodes (2101-2105),
   - geometric data of the pipelines (2201-2206),
   - load conditions,
   - coverage factor of the measuring sensors with respect to the critical areas defined on the basis of the residence time of the natural gas inside the pipelines (2201-2206).

3. Method according to claim 2, **wherein** the load conditions include one or more among natural gas inlet points, natural gas outlet points, maximum outlet values, and the input of the pressure levels at the control stations.

4. Method according to any of the preceding claims, **wherein** the simulation step (1020) includes a Monte Carlo simulation of the structure of the natural gas network (2000).

5. Method according to any of claims 1 to 4, **wherein** the calculation of the average travel time includes the calculation of the pressure drop in an i-th pipeline according to the equation

$$\text{Eq.1)} \quad \frac{\partial \Delta P_i}{\partial m_i} = \frac{f_i \, |m_i| \, L_i}{D_i \frac{PM}{RT} A_i^2 P_{i,out}}$$

where

$\Delta P$ = pressure drop
P = pressure
m = mass flow rate
f = friction factor
L = pipeline length
D = pipeline diameter
P = reference pressure for the pipeline
M = molar mass of the gas in transit
R = universal gas constant
T = reference temperature for the pipeline under assumption of isothermality
A = pipeline cross section
Pout = pressure at pipeline outlet
and where the "i" subscript indicates the i-th pipeline.

6. Method for controlling odorant gas injectors in a natural gas network (2000), including the steps of:

- calculation for the positioning of sensors for measuring an odorant gas according to any of the preceding claims,
- positioning of the sensors according to the result of the position calculation,
- feedback control of the odorant gas injectors using the odorant gas values measured by said sensors as input.


**Patentansprüche**

1. Berechnungsverfahren (1000) für die Positionierung von Sensoren zur Messung eines Geruchsgases in einem Erdgasnetz (2000), das die folgenden Schritte einschließt:

Erfassung (1010) von Daten über den physikalischen Zustand des Erdgasnetzes (2000),
Simulation (1020) des Erdgasnetzes (2000),
Berechnung (1030) für die Positionierung eines Geruchsgassensors, **dadurch gekennzeichnet, dass** das Erdgasnetz (2000) eine Vielzahl von Netzknoten (2101-2105) und eine Vielzahl von Rohrleitungen (2201-2206) umfasst und der Simulationsschritt (1020) die Berechnung der durchschnittlichen Wegezeit für jedes Paar von Knoten (2201-2206) umfasst.

2. Verfahren nach Anspruch 1, **wobei** der Schritt der Datenerfassung (1010) die Erfassung einer oder mehrerer der folgenden Daten einschließt:

- topografische Daten der Netzknoten (2101-2105),
- geometrische Daten der Rohrleitungen (2201-2206),
- Lastbedingungen,
- Abdeckungsfaktor der Sensoren in Bezug auf die kritischen Bereiche, die auf der Grundlage der Verweilzeit des Erdgases in den Rohrleitungen definiert werden (2201-2206).

3. Verfahren nach Anspruch 2, **wobei** die Lastbedingungen einen oder mehrere der folgenden Punkte umfassen: Erdgaseinlasspunkte, Erdgasauslasspunkte, maximale Auslasswerte und die Eingabe der Druckniveaus an den Kontrollstationen.

4. Verfahren nach einem der vorstehenden Ansprüche, **wobei** der Simulationsschritt (1020) eine Monte-Carlo-Simulation der Struktur des Erdgasnetzes (2000) umfasst.

5. Verfahren nach einem der Ansprüche 1 bis 4, **wobei** die Berechnung der durchschnittlichen Wegezeit die Berechnung des Druckabfalls in einer i-ten Rohrleitung gemäß der Gleichung

$$\text{Eq.1)} \quad \frac{\partial \Delta P_i}{\partial m_i} = \frac{f_i \, |m_i| \, L_i}{D_i \frac{PM}{RT} A_i^2 P_{i,out}}$$

einschließt,
wobei

$\Delta P$ = Druckabfall
P = Druck
m = Massendurchsatz
f = Reibungsfaktor
L = Länge der Rohrleitung
D = Durchmesser der Rohrleitung
P = Referenzdruck für die Rohrleitung
M = molare Masse des durchströmenden Gases
R = universelle Gaskonstante
T = Referenztemperatur für die Rohrleitung unter der Annahme von Isothermie
A = Querschnitt der Rohrleitung
$P_{out}$ = Druck am Ausgang der Rohrleitung
und wobei das tiefgestellte "i" die i-te Pipeline bezeichnet.

6. Verfahren zur Steuerung von Geruchsgaseinspritzdüsen in einem Erdgasnetz (2000), das die folgenden Schritte einschließt:

- Berechnung der Positionierung von Sensoren zur Messung eines Geruchsgases nach einem der vorhergehenden Ansprüche,
- Positionierung der Sensoren entsprechend dem Ergebnis der Positionsberechnung,
- Rückkopplungssteuerung der Geruchsgaseinspritzdüsen unter Verwendung der von den Sensoren gemessenen Geruchsgaswerte als Eingang.

## Revendications

1. Procédé de calcul (1000) pour le positionnement de capteurs destinés à mesurer un gaz odorant dans un réseau de gaz naturel (2000), comprenant les étapes suivantes :

l'acquisition (1010) de données représentant l'état physique du réseau de gaz naturel (2000),
la simulation (1020) du réseau de gaz naturel (2000),
le calcul (1030) pour le positionnement du capteur de gaz odorant **caractérisé en ce que** le réseau de gaz naturel (2000) comprend une pluralité de noeuds de réseau (2101-2105) et une pluralité de pipelines (2201-2206) et que l'étape de simulation (1020) comprend le calcul du temps de trajet moyen pour chaque paire de noeuds (2201-2206).

2. Procédé selon la revendication 1, **dans lequel** l'étape d'acquisition des données (1010) comprend l'acquisition d'un ou plusieurs parmi :

- les données topographiques des noeuds du réseau (2101-2105),
- les données géométriques des pipelines (2201-2206),
- les conditions de charge,
- le facteur de couverture des capteurs de mesure par rapport aux zones critiques définies sur la base du temps de séjour du gaz naturel à l'intérieur des pipelines (2201-2206).

**3.** Procédé selon la revendication 2, **dans lequel** les conditions de charge comprennent un ou plusieurs des points d'entrée de gaz naturel, des points de sortie de gaz naturel, des valeurs de sortie maximales, et l'entrée des niveaux de pression aux stations de contrôle.

**4.** Procédé selon l'une quelconque des revendications précédentes, **dans lequel** l'étape de simulation (1020) comprend une simulation de Monte Carlo de la structure du réseau de gaz naturel (2000).

**5.** Procédé selon l'une quelconque des revendications 1 à 4, **dans lequel** le calcul du temps de trajet moyen comprend le calcul de la chute de pression dans un i-ième pipeline selon l'équation suivante

$$\text{Eq.1)} \qquad \frac{\partial \Delta P_i}{\partial m_i} = \frac{f_i \left| m_i \right| L_i}{D_i \frac{PM}{RT} A_i^2 P_{i,out}}$$

où

    $\Delta P$ = chute de pression
    P = pression
    m = débit massique
    f = facteur de friction
    L = longueur du pipeline
    D = diamètre du pipeline
    P = pression de référence pour le pipeline
    M = masse molaire du gaz en transit
    R = constante universelle des gaz
    T = température de référence pour le pipeline dans l'hypothèse d'une isothermalité
    A= section transversale du pipeline
    Pout = pression à la sortie du pipeline
    et où l'indice « i » indique le i-ième pipeline.

**6.** Procédé de contrôle des injecteurs de gaz odorants dans un réseau de gaz naturel (2000), comprenant les étapes suivantes :

    - le calcul de positionnement des capteurs de mesure d'un gaz odorant selon l'une quelconque des revendications précédentes,
    - le positionnement des capteurs en fonction du résultat du calcul de la position,
    - la commande par rétroaction des injecteurs de gaz odorant en utilisant les valeurs de gaz odorant mesurées par lesdits capteurs comme données d'entrée.

*Fig. 1*

1000

```
┌─────────────┐
│    1010     │
└─────────────┘
       │
       ▼
┌─────────────┐
│    1020     │
└─────────────┘
       │
       ▼
┌─────────────┐
│    1030     │
└─────────────┘
```

*Fig. 2*

2000

*Fig. 3*

4000

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3634053 A
- US 3854894 A
- US 3686930 A

- EP 1030098 A2
- US 2014149054 A1